# EUROPEAN PATENT APPLICATION

(11) **EP 2 040 297 A1**
(43) Date of publication of application: **25.03.2009**
(21) Application number: 07116656.5
(22) Date of filing: 18.09.2007
(51) Int. Cl.: H01L 23/50, H01L 23/64, H01L 23/498

(54) **Decoupling capacitor assembly, integrated circuit/decoupling capacitor assembly and method for fabricating the same**

(71) Applicant: Research In Motion Limited, Waterloo, Ontario N2L 3W8 (CA)
(72) Inventor: Winger, Lyall, Waterloo Ontario N2T 1A6 (CA)
(74) Representative: Rickard, David John

(57) **Abstract**

A decoupling capacitor/integrated circuit assembly including: an integrated circuit assembly comprising a carrier containing an integrated circuit, the carrier comprising connectors on a base thereof defining a space on the base having no connectors, the connectors providing an electrical connection to the integrated circuit, one of the connectors designated as a power connector and another of the connectors designated as a ground connector; and a decoupling capacitor provided in the space on the base of the carrier and electrically connected to the power and ground connectors, wherein the decoupling capacitor is sized to fit between the integrated circuit assembly and a structure to which the integrated circuit assembly is to be connected.

## Description

This application relates generally to decoupling capacitors and integrated circuits and in particular, to a method for assembling a decoupling capacitor with an integrated circuit.

In the field of electronics and, in particular, the use of integrated circuits (ICs) on printed circuit boards (PCBs), the switching of ICs can result in transient energy being coupled into the power supply circuit. This coupling of transient energy can be reduced or avoided by the use of a "decoupling" capacitor placed between the power and ground connections of the IC.

In some cases, the decoupling capacitors are mounted on the PCB as near as possible to the IC and through holes or the like are used to connect leads from the decoupling capacitor to the power and ground planes or, via traces in the PCB to the power and ground leads of the IC itself. In these cases, additional board space is needed and, in the case of vias being used for connection, internal board space is needed.

In other cases, decoupling capacitors are mounted on the top of an IC or on the opposite side of the PCB from the IC to be decoupled, however, these arrangements result in increased height of the assembled PCB board.

In still other cases, the decoupling capacitor is mounted on the printed circuit board beneath the integrated circuit, such as a dual-in-line circuit. The decoupling capacitor is dimensioned to fit in a space between the two rows of leads extending from the conventional dual-in-line integrated circuit. In this case, the decoupling capacitor has two electrically active leads that are bent downwardly and are plugged into the PCB, with these leads from the capacitor being inserted into the through holes to which the ground and power supply conductors are connected. The associated IC is then positioned over the capacitor and inserted into the board such that the power supply leads of the IC will be positioned in the same through holes of the printed circuit board in which the two electrically active capacitor leads have been inserted. Similar approaches have been proposed with regard to other types of ICs. In some cases, the decoupling capacitor is provided with dedicated through-holes for connection to the PCB and vias in the PCB are used to connect the leads of the decoupling capacitor to the ground and power leads of the IC.

Unfortunately, when through holes, traces, or leads are used, the circuits formed, including the decoupling capacitors, can become highly inductive at high frequencies as a consequence of the shape and length of the leads and interconnection traces between the decoupling capacitor and the integrated circuit which it decouples. In fact, the inductance of the leads and printed circuit board traces may be sufficiently high to nullify the decoupling effect of the capacitor.

A further disadvantage arises from additional operations that may be required in the fabrication of the PCB or in the placement of the components because of the formation of vias or the need to first mount the decoupling capacitor on the PCB.

The issues of PCB board space, board height, and the like are particularly important in the area of mobile devices where there is constant pressure to produce smaller devices and include more and more functionality on the smaller devices.

As such, there is a need for an improved decoupling capacitor assembly, integrated circuit/decoupling capacitor assembly, and method of assembling a decoupling capacitor to an IC assembly.

### General

According to one aspect of embodiments described herein, there may be provided a decoupling capacitor/integrated circuit assembly including: an integrated circuit assembly comprising a carrier containing an integrated circuit, the carrier comprising connectors on a base thereof defining a space on the base having no connectors, the connectors providing an electrical connection to the integrated circuit, one of the connectors designated as a power connector and another of the connectors designated as a ground connector; and a decoupling capacitor provided in the space on the base of the carrier and electrically connected to the power and ground connectors, wherein the decoupling capacitor is sized to fit between the integrated circuit assembly and a structure to which the integrated circuit assembly is to be connected.

In another aspect, the decoupling capacitor/integrated circuit assembly may include traces applied to a base of the carrier leading from the power and ground connectors to the decoupling capacitor to provide the electrical connection. In this case, the decoupling capacitor may include solder pad connectors to connect to the traces.

In another case, the carrier may be made of plastic or of ceramic or another appropriate material.

In yet another case, the decoupling capacitor may be a thin film capacitor.

In yet another case, the carrier may be a ball gate array package, however other package types may also be used.

According to another aspect herein, there may be provided a method of fabricating a decoupling capacitor/integrated circuit assembly, the method including: providing an integrated circuit assembly comprising a carrier containing an integrated circuit, the carrier comprising connectors on a base thereof defining a space on the base having no connectors, the connectors providing an electrical connection to the integrated circuit, one of the connectors designated as a power connector and another of the connectors designated as a ground connector; and electrically connecting a decoupling capacitor to the power and ground connectors, wherein the decoupling capacitor is sized to fit in the space on the base of the carrier and between the integrated circuit assembly and a structure to which the integrated circuit assembly is to be connected.

In another case, the method may include applying traces to the base of the carrier leading from the power and ground connectors to the space on the base having no connectors.

In another case, the method may include applying balls to the connectors on the base of the carrier in order to form a ball gate array package.

According to another aspect herein, there may be provided a decoupling capacitor assembly including: a carrier for an integrated circuit, the carrier comprising a top for receiving an integrated circuit and a base having connectors, the connectors providing an electrical connection to the integrated circuit, one of the connectors designated as a power connector and another of the connectors designated as a ground connector; and a decoupling capacitor electrically connected to the power and ground connectors, wherein the decoupling capacitor is sized to fit in the space on the base of the carrier and between the carrier and a structure to which the carrier is to be connected.

In another case, the decoupling capacitor assembly may include traces applied to a base of the carrier leading from the power and ground connectors to the decoupling capacitor to provide the electrical connection. In this case, the decoupling capacitor may include solder pad connectors to connect to the traces.

In another case, similar to the above, the carrier may be made of plastic or of ceramic or another appropriate material.

In yet another case, the decoupling capacitor may be a thin film capacitor.

In yet another case, the carrier may be a ball gate array package, however other package types may also be used.

According to another aspect herein, there may be provided a method of fabricating a decoupling capacitor assembly, the method including: providing a carrier for an integrated circuit, the carrier comprising a top for receiving an integrated circuit and a base having connectors, the connectors providing an electrical connection to the integrated circuit, one of the connectors designated as a power connector and another of the connectors designated as a ground connector; and electrically connecting a decoupling capacitor to the power and ground connectors, wherein the decoupling capacitor is sized to fit in the space on the base of the carrier and between the carrier and a structure to which the carrier is to be connected.

In another case, the method may include applying traces to the base of the carrier leading from the power and ground connectors to the space on the base having no connectors.

In another case, the method may include applying balls to the connectors on the base of the carrier in order to form a ball gate array package.

In yet another case, the method may include connecting an integrated circuit to the top of the carrier.

Other aspects of the assemblies and methods will be apparent from the following description.

### Brief Description of the Drawings

For a better understanding of the embodiments described herein and to show more clearly how they may be carried into effect, reference will now be made, by way of example only, to the accompanying drawings which show the example embodiments and in which:

FIG. 1 is a block diagram of an example embodiment of a mobile communication device;

FIG. 2 is a block diagram of an example embodiment of a communication subsystem component of the mobile communication device of FIG. 1;

FIG. 3 is a schematic side view of an example embodiment of an integrated circuit/decoupling capacitor (IC/DC) assembly;

FIG. 4 is a schematic bottom view of the IC/DC assembly of FIG. 3;

FIG. 5 is a flowchart of an example embodiment of a method for mounting a decoupling capacitor;

FIG. 6 is a flowchart of an example embodiment of another method for mounting a decoupling capacitor; and

FIG. 7 is a schematic view of the IC/DC assembly of FIGS. 3 and 4 mounted on a printed circuit board.

### Description of Preferred Embodiments

It will be appreciated that for simplicity and clarity of illustration, where considered appropriate, reference numerals may be repeated among the figures to indicate corresponding or analogous elements or steps. In addition, numerous specific details are set forth in order to provide a thorough understanding of the example embodiments described herein. However, it will be understood by those of ordinary skill in the art that the embodiments described herein may be practiced without these specific details. In other instances, well-known methods, procedures and components have not been described in detail so as not to obscure the embodiments described herein. Furthermore, this description is not to be considered as limiting the scope of the embodiments described herein in any way, but rather as merely describing the implementation of the various embodiments described herein.

Some of the embodiments make use of a mobile communication device, sometimes referred to herein as a mobile device, that is a two-way communication device with advanced data communication capabilities having the capability to communicate in a wireless or wired fashion with other computing devices. The mobile device may also include the capability for voice communications. Depending on the functionality provided by the mobile device, it may be referred to as a data messaging device, a cellular telephone with data messaging capabilities, a wireless Internet appliance, or a data communication device (with or without telephony capabilities). Examples of mobile communication devices include cellular phones, cellular smart-phones, wireless organizers, personal digital assistants, handheld wireless communication devices, wirelessly enabled notebook computers and the like. Typically, the mobile device communicates with other devices through a network of transceiver stations. The mobile device may also include the capability to communicate wirelessly with other mobile devices or with accessory devices using personal area networking (PAN) technologies such as infrared, Bluetooth, or the like.

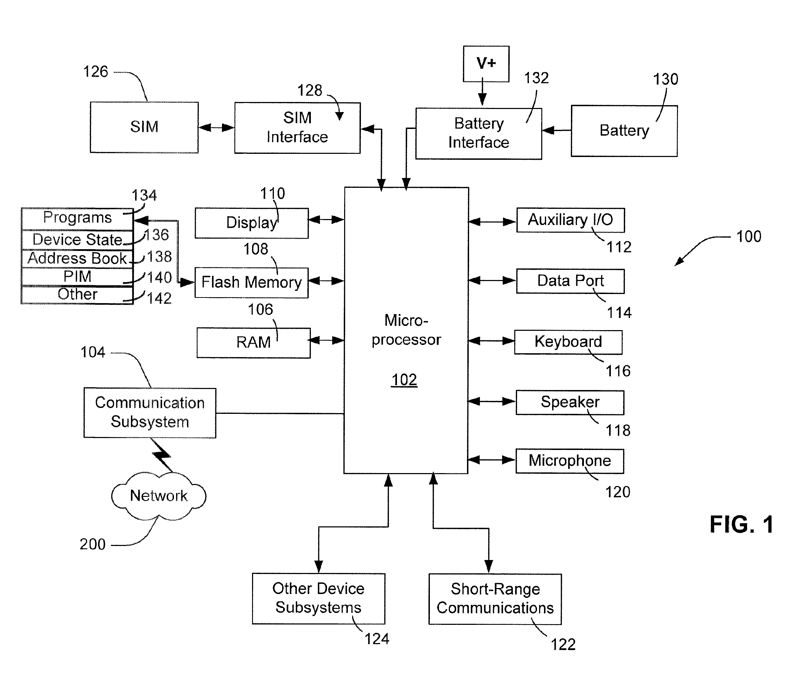

Referring first to FIG. 1, shown therein is a block diagram of a mobile device 100 in one example implementation. The mobile device 100 comprises a number of components, the controlling component being a main processor 102 which controls the overall operation of mobile device 100. Communication functions, including data and voice communications, are performed through a communication subsystem 104. The communication subsystem 104 receives messages from and sends messages to a wireless network 200. In some implementations of the mobile device 100, the communication subsystem 104 is configured in accordance with the Global System for Mobile Communication (GSM) and General Packet Radio Services (GPRS) standards. The GSM/GPRS wireless network is used worldwide. Other standards that can be used include the Enhanced Data GSM Environment (EDGE), Universal Mobile Telecommunications Service (UMTS), Code Division Multiple Access (CDMA), and Intelligent Digital Enhanced Network (iDEN^{™}) standards. New standards are still being defined, but it is believed that they will have similarities to the network behavior described herein, and it will be understood by persons skilled in the art that the embodiments described herein can use any other suitable standards that are developed in the future. The wireless link connecting the communication subsystem 104 with the wireless network 200 represents one or more different Radio Frequency (RF) channels, operating according to defined protocols specified for GSM/GPRS communications. With newer network protocols, these channels are capable of supporting both circuit switched voice communications and packet switched data communications.

Although the wireless network 200 associated with the mobile device 100 is a GSM/GPRS wireless network in some implementations, other wireless networks can also be associated with the mobile device 100 in other implementations. The different types of wireless networks that can be employed include, for example, data-centric wireless networks, voice-centric wireless networks, and dual-mode networks that can support both voice and data communications over the same physical base stations. Combined dual-mode networks include, but are not limited to, Code Division Multiple Access (CDMA) or CDMA2000 networks, iDEN networks, GSM/GPRS networks (as mentioned above), and future third-generation (3G) networks like EDGE and UMTS. Some other examples of data-centric networks include WiFi 802.11, Mobitex^{™} and DataTAC^{™} network communication systems. Examples of other voice-centric data networks include Personal Communication Systems (PCS) networks like GSM and Time Division Multiple Access (TDMA) systems.

The main processor 102 also interacts with additional subsystems such as a Random Access Memory (RAM) 106, a flash memory 108, a display 110, an auxiliary input/output (I/O) subsystem 112, a data port 114, a keyboard 116, a speaker 118, a microphone 120, short-range communications 122, and other device subsystems 124.

Some of the subsystems of the mobile device 100 perform communication-related functions, whereas other subsystems can provide "resident" or on-device functions. By way of example, the display 110 and the keyboard 116 can be used for both communication-related functions, such as entering a text message for transmission over the network 200, and device-resident functions such as a calculator or task list. Operating system software used by the main processor 102 is typically stored in a persistent store such as the flash memory 108, which can alternatively be a read-only memory (ROM) or similar storage element (not shown). Those skilled in the art will appreciate that the operating system, specific device applications, or parts thereof, can be temporarily loaded into a volatile store such as the RAM 106.

The mobile device 100 can send and receive communication signals over the wireless network 200 after required network registration or activation procedures have been completed. Network access is associated with a subscriber or user of the mobile device 100. To identify a subscriber, the mobile device 100 may require a SIM/RUIM card 126 (i.e. Subscriber Identity Module or a Removable User Identity Module) to be inserted into a SIM/RUIM interface 128 in order to communicate with a network. Accordingly, the SIM card/RUIM 126 and the SIM/RUIM interface 128 are entirely optional.

The SIM card or RUIM 126 is one type of a conventional "smart card" that can be used to identify a subscriber of the mobile device 100 and to personalize the mobile device 100, among other things. Without the SIM card 126, the mobile device 100 is not fully operational for communication with the wireless network 200. By inserting the SIM card/RUIM 126 into the SIM/RUIM interface 128, a subscriber can access all subscribed services. Services can include: web browsing and messaging such as e-mail, voice mail, Short Message Service (SMS), and Multimedia Messaging Services (MMS). More advanced services can include: point of sale, field service and sales force automation. The SIM card/RUIM 126 includes a processor and memory for storing information. Once the SIM card/RUIM 126 is inserted into the SIM/RUIM interface 128, it is coupled to the main processor 102. In order to identify the subscriber, the SIM card/RUIM 126 contains some user parameters such as an International Mobile Subscriber Identity (IMSI). An advantage of using the SIM card/RUIM 126 is that a subscriber is not necessarily bound by any single physical mobile device. The SIM card/RUIM 126 may store additional subscriber information for a mobile device as well, including datebook (or calendar) information and recent call information. Alternatively, user identification information can also be programmed into the flash memory 108.

The main processor 102, in addition to its operating system functions, enables execution of software applications 134 on the mobile device 100. The subset of software applications 134 that control basic device operations, including data and voice communication applications, will normally be installed on the mobile device 100 during its manufacture. The programs 134 can include an email program, a web browser, an attachment viewer, and the like.

The mobile device 100 further includes a device state module 136, an address book 138, a Personal Information Manager (PIM) 140, and other modules 142. The device state module 136 can provide persistence, i.e. the device state module 136 ensures that important device data is stored in persistent memory, such as the flash memory 108, so that the data is not lost when the mobile device 100 is turned off or loses power. The address book 138 can provide information for a list of contacts for the user. For a given contact in the address book, the information can include the name, phone number, work address and email address of the contact, among other information. The other modules 142 can include a configuration module (not shown) as well as other modules that can be used in conjunction with the SIM/RUIM interface 128.

The PIM 140 has functionality for organizing and managing data items of interest to a subscriber, such as, but not limited to, e-mail, calendar events, voice mails, appointments, and task items. A PIM application has the ability to send and receive data items via the wireless network 200. PIM data items may be seamlessly integrated, synchronized, and updated via the wireless network 200 with the mobile device subscriber's corresponding data items stored and/or associated with a host computer system. This functionality creates a mirrored host computer on the mobile device 100 with respect to such items. This can be particularly advantageous when the host computer system is the mobile device subscriber's office computer system.

Additional applications can also be loaded onto the mobile device 100 through at least one of the wireless network 200, the auxiliary I/O subsystem 112, the data port 114, the short-range communications subsystem 122, or any other suitable device subsystem 124. This flexibility in application installation increases the functionality of the mobile device 100 and can provide enhanced on-device functions, communication-related functions, or both. For example, secure communication applications can enable electronic commerce functions and other such financial transactions to be performed using the mobile device 100.

The data port 114 enables a subscriber to set preferences through an external device or software application and extends the capabilities of the mobile device 100 by providing for information or software downloads to the mobile device 100 other than through a wireless communication network. The alternate download path may, for example, be used to load an encryption key onto the mobile device 100 through a direct and thus reliable and trusted connection to provide secure device communication.

The data port 114 may be any suitable port that enables data communication between the mobile device 100 and another computing device. The data port may be a serial or a parallel port. In some instances, the data port 114 may be a USB port that includes data lines for data transfer and a supply line that can provide a charging current to charge the mobile device 100.

The short-range communications subsystem 122 provides for communication between the mobile device 100 and other mobile devices, computer systems or accessory devices, without the use of the wireless network 200. For example, the subsystem 122 can include a wireless transmitter/receiver and associated circuits and components for short-range communication. Examples of short-range communication standards include those developed by the Infrared Data Association (IrDA), Bluetooth, and the 802.11 family of standards developed by IEEE. These short-range communication standards allow the formation of wireless connections between or among mobile devices and accessory devices and, in some cases, allow the formation of personal area networks (PANs) involving several devices. The establishment of short-range communications is described in greater detail below.

In use, a received signal such as a text message, an e-mail message, or web page download will be processed by the communication subsystem 104 and input to the main processor 102. The main processor 102 will then process the received signal for output to the display 110 or alternatively to the auxiliary I/O subsystem 112. A subscriber can also compose data items, such as e-mail messages, for example, using the keyboard 116 in conjunction with the display 110 and possibly the auxiliary I/O subsystem 112. The auxiliary subsystem 112 can include devices such as: a touch screen, mouse, track ball, infrared fingerprint detector, or a roller wheel with dynamic button pressing capability. The keyboard 116 is preferably an alphanumeric keyboard and/or telephone-type keypad. However, other types of keyboards can also be used. A composed item can be transmitted over the wireless network 200 through the communication subsystem 104.

For voice communications, the overall operation of the mobile device 100 is substantially similar, except that the received signals are output to the speaker 118, and signals for transmission are generated by the microphone 120. Alternative voice or audio I/O subsystems, such as a voice message recording subsystem, can also be implemented on the mobile device 100. Although voice or audio signal output is accomplished primarily through the speaker 118, the display 110 can also be used to provide additional information such as the identity of a calling party, duration of a voice call, or other voice call related information.

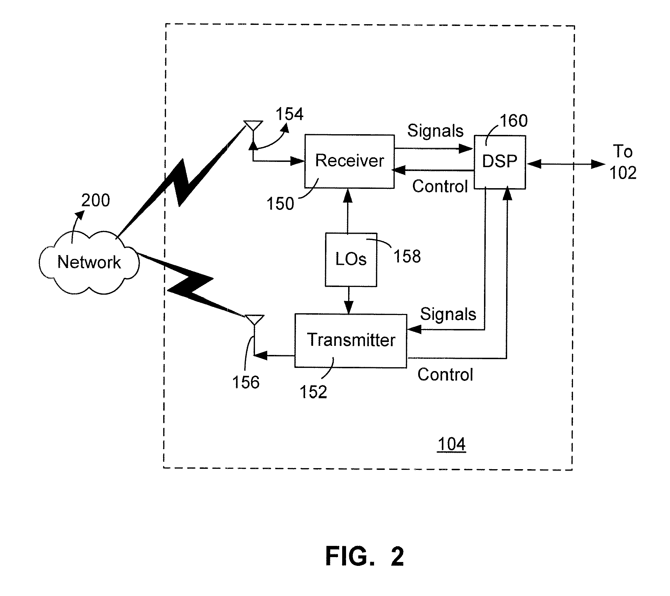

Referring now to FIG. 2, a block diagram of an example embodiment of the communication subsystem component 104 of FIG. 1 is shown. The communication subsystem 104 comprises a receiver 150 and a transmitter 152, as well as associated components such as one or more embedded or internal antenna elements 154, 156, Local Oscillators (LOs) 158, and a communications processor 160 for wireless communication. The communications processor 160 can be a Digital Signal Processor (DSP). As will be apparent to those skilled in the field of communications, the particular design of the communication subsystem 104 can depend on the communication network with which the mobile device 100 is intended to operate. Thus, it should be understood that the design illustrated in FIG. 2 serves only as an example.

Signals received by the antenna 154 through the wireless network 200 are input to the receiver 150, which can perform such common receiver functions as signal amplification, frequency down conversion, filtering, channel selection, and analog-to-digital (A/D) conversion. A/D conversion of a received signal allows more complex communication functions such as demodulation and decoding to be performed by the communications processor 160. In a similar manner, signals to be transmitted are processed, including modulation and encoding, by the communications processor 160. These processed signals are input to the transmitter 152 for digital-to-analog (D/A) conversion, frequency up conversion, filtering, amplification and transmission over the wireless network 200 via the antenna 156. The communications processor 160 not only processes communication signals, but also provides for receiver and transmitter control. For example, the gain/attenuation applied to communication signals in the receiver 150 and transmitter 152 can be adaptively controlled through automatic gain/attenuation control algorithms implemented in the communications processor 160.

The wireless link between the mobile device 100 and the wireless network 200 can contain one or more different channels, typically different RF channels, and associated protocols used between the mobile device 100 and the wireless network 200. An RF channel is a limited resource that must be conserved, typically due to limits in overall bandwidth and limited battery power of the mobile device 100.

When the mobile device 100 is fully operational, the transmitter 152 is typically keyed or turned on only when it is sending to the wireless network 200 and is otherwise turned off to conserve resources. Similarly, the receiver 150 is periodically turned off to conserve power until it is needed to receive signals or information (if at all) during designated time periods.

Using the above described general mobile device as an example device, which includes PCBs, integrated circuits, decoupling capacitors and the like, an integrated circuit/decoupling capacitor assembly and method of fabricating the same will now be described in further detail.

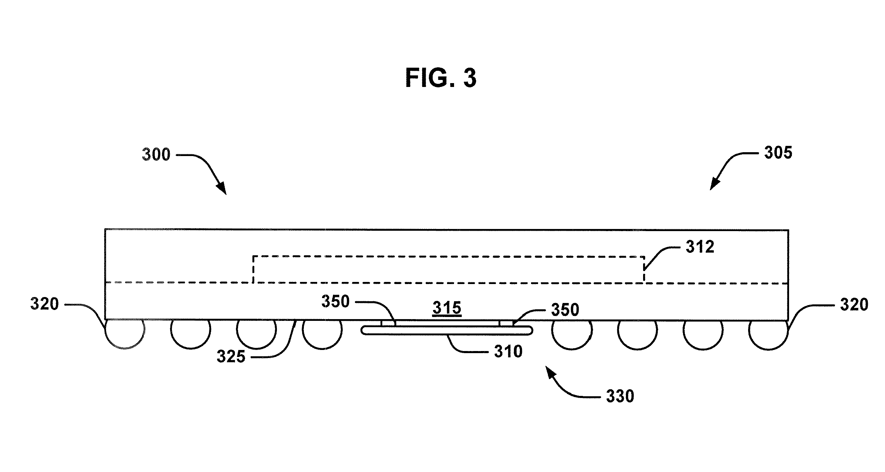

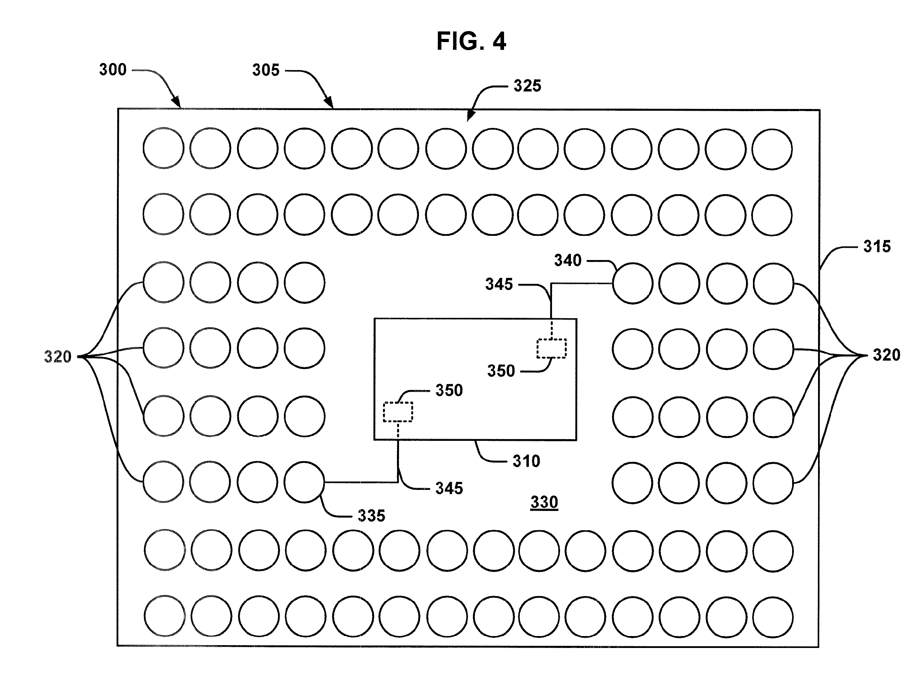

FIG. 3 is a schematic side view of an example embodiment of an integrated circuit/decoupling capacitor (IC/DC) assembly 300. FIG. 4 is a schematic bottom view of the IC/DC assembly 300 of FIG. 3. The IC/DC assembly 300 includes an integrated circuit (IC) assembly 305 and a decoupling capacitor (DC) 310.

As shown in FIGS. 3 and 4, the IC assembly 305 includes an IC die 312 (shown in dotted lines) that is mounted on a carrier 315. The carrier 315 is fabricated using known methods to provide electrical connections between the IC die 312 and connectors (not shown) on a base 325 of the carrier 315. The IC assembly 305 includes a plurality of solder "balls" 320 in electrical contact with the connectors on the base 325 of the IC assembly 305 (the balls 320 form a ball-grid array 330). The balls 320 are typically arranged around the periphery of the base 325 of the IC assembly 305 and typically form or can be arranged to form a space 330 under the IC assembly 305 in which there are no balls 320. Of the plurality of balls 320, there is a power lead 335 and a ground lead 340. The DC 310 is appropriately sized to fit into the space 330 under the IC assembly 305 and is positioned such that an electrical connection is made between the DC 310 and the power lead 335 and the ground lead 340. In this particular example, the carrier 315 is preformed with traces 345 (shown on FIG. 4) between pads 350 on the DC 310 and the power lead 335 and the ground lead 340 to form the electrical connection between the DC 310 and the power lead 335 and the ground lead 340. It is understood that other forms of electrical connections may be possible, including, as one example, the use of vias in the base 325 of the carrier 315.

The DC 310 is preferably a thin-film type of capacitor as is known to those of skill in the art. The DC 310 is selected such that the DC 310 will fit within the space beneath the IC assembly 305 and not interfere with the IC assembly 305 when the IC assembly 305 is installed on a printed circuit board (PCB) or the like.

In this particular example, the IC assembly 305 is shown as a ball-grid array (BGA) package. However, it will be understood that other types of IC assemblies 305 may be substituted with suitable modifications, including SIP, DIN, PGA, POP or the like. In each case, the IC assembly includes a carrier and connectors on a base thereof such that a DC can be provided in a space under the carrier where there are no connectors and be configured such that the DC will fit within the space and not interfere with the IC assembly when the IC assembly is installed on a printed circuit board (PCB) or the like.

The carrier 315 may be made of ceramic, plastic or other appropriate material. As will be understood, some factors in making a choice of the carrier material are coefficient of thermal expansion (CTE), conductor resistivity, dielectric constant, dielectric loss tangent, and thermal conductivity. CTE can be important because mismatches between the carrier and the die (first level interconnect) or printed wiring board (PWB) (second level interconnect) can play a factor in reliability. CTE mismatches generate shear stresses that can cause joints to fail. As the operational frequencies rise and supply voltages decrease the electrical characteristics of the carrier materials can be important. The signal integrity, as it propagates through the carrier, is a function of conductor resistivity, dielectric constant and the loss tangent. Both the dielectric constant and loss tangent can be functions of the frequency. In general, the dielectric loss tangent is less affected by frequency for ceramic packages, while for organic packages the loss tangent can have resonances at higher frequencies especially above 1 GHz. Table 1 illustrates some of the these properties for various materials.

**TABLE 1: Carrier material properties**

| | | Ceramic | | Organic | |
|---|---|---|---|---|---|
| | Unit | Alumina | HiTCE | FR-4 | BT-resin |
| Electrical | | | | | |
| Dielectric Constant (1 MHz/3.2GHz) | | 10 | 5.4/5.4 | 5.5/- | 4.7/- |
| Dielectric Loss Angle (1 MHz/3.2GHz) | (x10-4) | 24 | 7/20 | 200/- | 100/- |
| Metallization Sheet Resistance | mW /Sq. | 10 | 3 | 1 | 1 |
| Thermal | | | | | |
| Thermal Conductivity | W/m°k | 18 | 2 | 0.2 | 0.2 |
| Coefficient of Linear Thermal Expansion | 1/°C (x10-6) | 7 | 12.2 | 12∼14 | 13∼16 |

Alumina is a common material for carriers but its limitations are its low CTE, which may create reliability issues for larger packages (>35mm), and its high conductor resistance and dielectric constant, which may not be as useful in high power or very high frequency designs.

Organic laminate-based carriers have low resistance copper interconnects and low dielectric constants. One limitation of organic carriers is high CTE, which may create a CTE mismatch between the die and carrier. Underfill between the carrier and die can help compensate but may not be sufficient to prevent mismatch. Organic materials are also generally more subject to moisture absorption, which can cause issues with reliability.

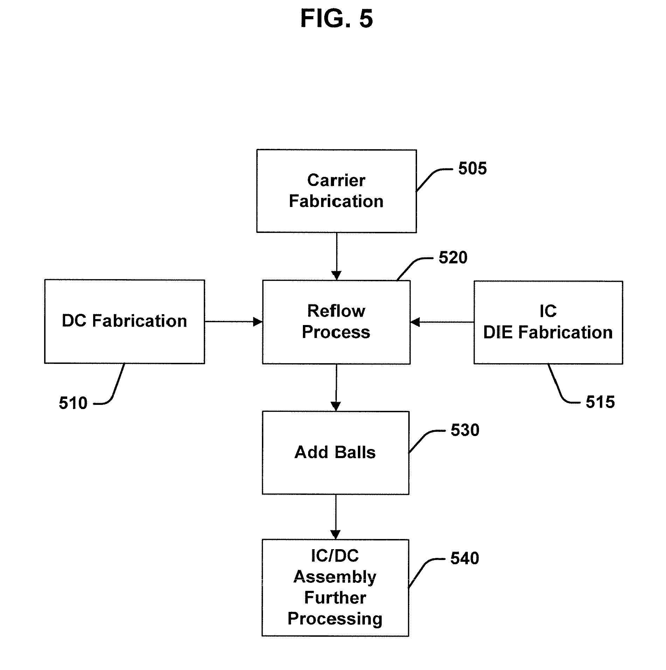

Figure 5 is a flowchart of an example method of fabricating the IC/DC assembly 300. In this example method, the decoupling capacitor is mounted on the carrier 315 during the process of assembling the IC die 312 and carrier 315 to create the IC assembly 305.

At 505, the carrier 315 is fabricated using well known methods to a point prior to attachment of the IC die 312 to the carrier 315. During this fabrication process, the carrier 315 is provided with the traces 345 between the pads 350 on the DC 310 and the power lead 335 and the ground lead 340. The traces 345 may be added by methods as will be understood by one of skill in the art, including etching, photo mask, laser, or the like. As will be understood, the traces 345 represent an electrical connection between the DC 310 and the power lead 335 and the ground lead 340. As indicated above, other forms of connection may also be available as will be understood to one of skill in the art.

At 510 and 515, the DC 310 and the IC die 312 are also fabricated using known methods in preparation for being assembled into the IC/DC assembly 300.

At 520, the IC die 312 and the DC 310 are then connected to the carrier 315 using an appropriate technique such as, for example, a surface mount technology (SMT). In some cases, a reflow technique or a flip chip technique may be appropriate. In SMT, solder paste can be applied to the carrier 315 to attach the DC 310 to the carrier 315. If a solder paste is selected that matches the bump composition for connecting the IC die 312, it may be possible to use a single pass reflow in order to attach both the IC die 312 and the DC 310 to the carrier 315. Common methods of applying solder paste are automated dispensing, through a needle or a pogo type valve, or by screening the paste. There are also various methods that can be used to reflow solder bumps or paste. For example, IR, resistively heated tunnel, and convection furnaces are all capable of reflowing solder. While in this example the DC 310 and the IC die 312 are connected to the carrier 315 at the same time in order to reduce the number of manufacturing steps and save time and cost, there may be situations where the DC 310 and IC die 312 may be connected to the carrier 315 separately. In either case, it will be understood that the connection methods and materials will need to be selected based on the number and sequence of steps in the process and other factors as will be understood by one of skill in the art. In a case where the DC 310 is connected to the carrier 315 in advance of the IC die 312, a DC assembly (not shown) will be created as a sub-assembly.

At 530, the lead balls 320 for the BGA 330 are then added to the carrier 315, with the power lead 335 and ground lead 340 being placed over the traces 345 on the carrier 315 in order to provide a connection from the DC 310 to the power lead 335 and ground lead 340 of the IC die 312.

At 540, the IC/DC assembly 300 is complete and can be tested and/or transferred for further processing, such as connection to a PCB or the like.

The formation of the connections for the IC die 312 and DC 310 to the carrier 315 in one reflow step can provide for a lower cost manufacturing process.

As noted above, an example carrier may include a BGA. The BGA can be effective because the BGA interconnect can be made very dense. The most common BGA interconnects include the following: Eutectic solder spheres D-BGA2 (eutectic-like solder sphere alloy with recessed package contact pad) or C-BGA3 (90/10 solder spheres, attached to the package with eutectic solder). Eutectic solder spheres are generally used on organic packages. Ceramic packages can be manufactured using either D-BGA or C-BGA technology, with D-BGA technology providing enhanced reliability. Hi-TCE ceramic packages can be manufactured with eutectic solder spheres or C-BGA technology, which provides enhanced reliability. High frequency devices generally need better control of the gap between the IC die and the carrier after reflow in order to maintain transmission characteristics required for signal integrity across the connection. The gap can be established by the dimensional tolerance of the solder balls and the carrier pads to meet the needs of very high frequency devices.

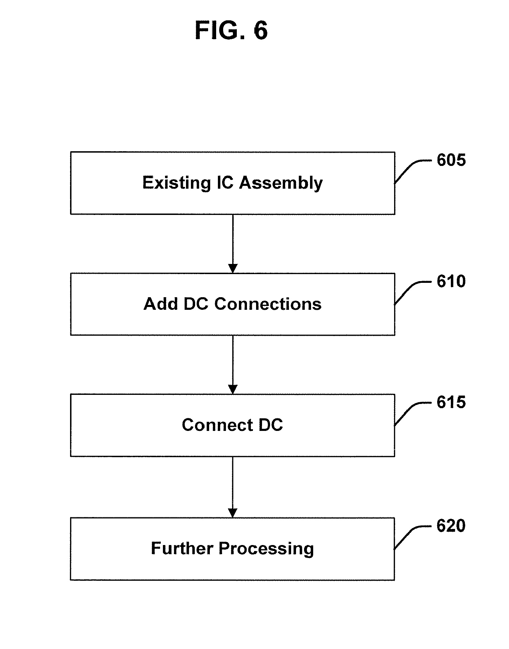

An alternative example method of fabricating the IC/DC assembly 300 is shown in FIG. 6. At 605, a conventional IC assembly 305 is provided, in this case a BGA package. At 610, the IC assembly 305 is then provided with an electrical connection between the ground lead 335 and power lead 340 towards the space 330 on the base 325 of the IC assembly 305, for example, by placing traces 345 on the IC assembly 305. At 615, the DC 310 is connected to the base 325 of the IC assembly 305 such that connectors 350 on the DC 310 connect with the traces 345 leading to the power lead 335 and ground lead 340 of the IC assembly 305. At 540, the IC/DC assembly 300 is complete and can be tested and/or transferred for further processing, such as connection to a PCB or the like.

It will be understood that there are similar advantages in adding a DC to the base of an existing IC assembly to that of fabricating an IC/DC assembly, such as reducing board and via space used, reducing manufacturing steps and costs at the PCB assembly stage, and the like.

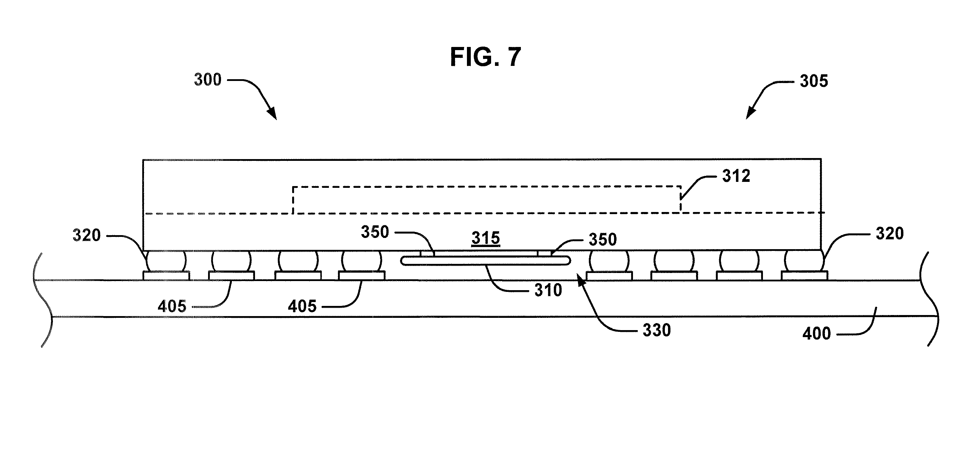

FIG. 7 is a schematic diagram of the IC/DC assembly 300 when mounted on a PCB 400. The IC/DC assembly 300 is placed onto the PCB 400 such that balls 320 on the IC/DC assembly 300 align with appropriate connections 405 on the PCB 400. As shown in Figure 7, the DC 310 is attached to the IC assembly and is also sized such that it fits between the IC assembly 305 and the PCB 400, preferably without contacting the PCB 400. It will be understood that the size and properties of the connectors (in this case balls 320) between the IC assembly 305 and the PCB 400 will be taken into account when determining the appropriate DC 310 and method of attaching DC 310 to the IC assembly 305.

As will be understood, the IC/DC assembly 300 may be mounted on the PCB 400 using any appropriate technology such as, for example, a surface mount method or the like.

The embodiments of the IC/DC assembly 300 described above have the advantages of reduced inductance in relation to the power and ground leads of the IC assembly 305 and preassembly of the IC/DC assembly 300 allows the assembly to be quickly and easily mounted on a PCB 400.

It should be understood that various modifications can be made to the example embodiments described and illustrated herein, without departing from the general scope of the appended claims. In particular, it should be understood that while the embodiments have been described for mobile communication devices, the embodiments are generally applicable to communications devices that are used in noisy environments.

## Claims

1. A decoupling capacitor/integrated circuit assembly comprising:
an integrated circuit assembly comprising a carrier containing an integrated circuit, the carrier comprising connectors on a base thereof defining a space on the base having no connectors, the connectors providing an electrical connection to the integrated circuit, one of the connectors designated as a power connector and another of the connectors designated as a ground connector; and
a decoupling capacitor provided in the space on the base of the carrier and
electrically connected to the power and ground connectors, wherein the decoupling capacitor is sized to fit between the integrated circuit assembly and a structure to which the integrated circuit assembly is to be connected.

2. A decoupling capacitor/integrated circuit assembly according to claim 1, further comprising traces applied to a base of the carrier leading from the power and ground connectors to the decoupling capacitor to provide the electrical connection.

3. A decoupling capacitor/integrated circuit assembly according to claim 1 or claim 2, wherein the carrier comprises a plastics or a ceramics material.

4. A decoupling capacitor/integrated circuit assembly according to any one of the preceding claims, wherein the decoupling capacitor comprises a thin film capacitor.

5. A decoupling capacitor/integrated circuit assembly according to any one of the preceding claims, wherein the carrier comprises a ball gate array package.

6. A decoupling capacitor/integrated circuit assembly according to claim 2 or any one of claims 3 to 5 when dependent on claim 2, wherein the decoupling capacitor comprises solder pad connectors to connect to the traces.

7. A method of fabricating a decoupling capacitor/integrated circuit assembly, the method comprising:
providing an integrated circuit assembly comprising a carrier containing an integrated circuit, the carrier comprising connectors on a base thereof defining a space on the base having no connectors, the connectors providing an electrical connection to the integrated circuit, one of the connectors designated as a power connector and another of the connectors designated as a ground connector; and
electrically connecting a decoupling capacitor to the power and ground connectors, wherein the decoupling capacitor is sized to fit in the space on the base of the carrier and between the integrated circuit assembly and a structure to which the integrated circuit assembly is to be connected.

8. A method according to claim 7, further comprising applying traces to the base of the carrier leading from the power and ground connectors to the space on the base having no connectors.

9. A method according to claim 7 or claim 8, further comprising applying balls to the connectors on the base of the carrier.

10. A method according to any one of claims 7 to 9 further comprising assembling the decoupling capacitor/integrated circuit assembly into a mobile device.

11. A decoupling capacitor assembly comprising:
a carrier for an integrated circuit, the carrier comprising a top for receiving an integrated circuit and a base having connectors, the connectors for providing an electrical connection to the integrated circuit, one of the connectors designated as a power connector and another of the connectors designated as a ground connector; and
a decoupling capacitor electrically connected to the power and ground connectors, wherein the decoupling capacitor is sized to fit in a space on the base of the carrier and between the carrier and a structure to which the carrier is to be connected.

12. A decoupling capacitor assembly according to claim 11, further comprising traces applied to a base of the carrier leading from the power and ground connectors to the decoupling capacitor to provide the electrical connection.

13. A decoupling capacitor assembly according to claim 11 or claim 12, wherein the carrier comprises a plastics or ceramics material.

14. A decoupling capacitor assembly according to any one of claims 11 to 13, wherein the decoupling capacitor comprises a thin film capacitor.

15. A decoupling capacitor/integrated circuit assembly according to claim 12 or claim 13 or claim 14 when dependent on claim 12, wherein the decoupling capacitor comprises solder pad connectors to connect to the traces.

16. A method of fabricating a decoupling capacitor assembly, the method comprising:
providing a carrier for an integrated circuit, the carrier comprising a top for receiving an integrated circuit and a base having connectors, the connectors providing an electrical connection to the integrated circuit, one of the connectors designated as a power connector and another of the connectors designated as a ground connector; and
electrically connecting a decoupling capacitor to the power and ground connectors, wherein the decoupling capacitor is sized to fit in a space on the base of the carrier and between the carrier and a structure to which the carrier is to be connected.

17. A method according to claim 16 further comprising applying traces to the base of the carrier leading from the power and ground connectors to a space on the base intended to have no connectors and connecting the decoupling capacitor to the traces to form the electrical connection.

18. A method according to claim 16 or claim 17 further comprising connecting an integrated circuit to the top of the carrier.

19. A method according to any one of claims 16 to 18 further comprising applying balls to the connectors on the base of the carrier.

20. A method according to any one of claims 16 to 19 further comprising assembling the decoupling capacitor assembly into a mobile device.

21. A mobile device comprising a decoupling capacitor assembly according to any one of claims 11 to 15.

## Amended claims

### Amended claims in accordance with Rule 137(2) EPC.

**1.** A decoupling capacitor/integrated circuit assembly (300) comprising:
an integrated circuit assembly (305) comprising a carrier (315) containing an integrated circuit (312), the carrier (315) comprising connectors on a base (325) thereof defining a space (330) on the base (325) having no connectors, the connectors providing an electrical connection to the integrated circuit (312), one of the connectors designated as a power connector and another of the connectors designated as a ground connector; and
a decoupling capacitor (310) provided in the space (330) on the base (325) of the carrier (315) and electrically connected to the power and ground connectors, wherein the decoupling capacitor (310) is sized to fit between the integrated circuit assembly (305) and a structure (400) to which the integrated circuit assembly (305) is to be connected;
wherein the decoupling capacitor/integrated circuit assembly (300) further comprises preformed traces applied to the base (325) of the carrier (315) leading from the power and ground connectors to the decoupling capacitor (310) to provide the electrical connection.

**2.** A decoupling capacitor/integrated circuit assembly (300) according to claim 1, wherein the carrier (315) comprises a plastics or a ceramics material.

**3.** A decoupling capacitor/integrated circuit assembly (300) according to any one of the preceding claims, wherein the decoupling capacitor (310) comprises a thin film capacitor.

**4.** A decoupling capacitor/integrated circuit assembly (300) according to any one of the preceding claims, wherein the carrier (315) comprises a ball gate array package.

**5.** A decoupling capacitor/integrated circuit assembly (300) according to any one of the preceding claims, wherein the decoupling capacitor (310) comprises solder pad connectors (350) to connect to the traces.

**6.** A method of fabricating a decoupling capacitor/integrated circuit assembly (300), the method comprising:
providing an integrated circuit assembly (305) comprising a carrier (315) containing an integrated circuit (312), the carrier (315) comprising connectors on a base (325) thereof defining a space (330) on the base (325) having no connectors, the connectors providing an electrical connection to the integrated circuit (312), one of the connectors designated as a power connector and
another of the connectors designated as a ground connector; and
electrically connecting a decoupling capacitor (310) to the power and ground connectors, wherein the decoupling capacitor (310) is sized to fit in the space (330) on the base (325) of the carrier (315) and between the integrated circuit assembly (305) and a structure (400) to which the integrated circuit assembly (305) is to be connected;
wherein the method further comprises applying preformed traces to the base (325) of the carrier (315) leading from the power and ground connectors to the space (330) on the base (325) having no connectors.

**7.** A method according to claim 6, further comprising applying balls (320) to the connectors on the base (325) of the carrier (315).

**8.** A method according to claim 6 or 7, further comprising assembling the decoupling capacitor/integrated circuit assembly (300) into a mobile device (100).

**9.** A decoupling capacitor assembly comprising:
a carrier (315) for an integrated circuit (312), the carrier (315) comprising a top for receiving an integrated circuit and a base (325) having connectors, the connectors for providing an electrical connection to an integrated circuit (312), one of the connectors designated as a power connector and another of the connectors designated as a ground connector; and
a decoupling capacitor (310) electrically connected to the power and ground connectors, wherein the decoupling capacitor (310) is sized to fit in a space (330) intended to have no connectors on the base (325) of the carrier (315) and between the carrier (315) and a structure (400) to which the carrier (315) is to be connected;
wherein the decoupling capacitor assembly further comprises preformed traces applied to the base (325) of the carrier (315) leading from the power and ground connectors to the decoupling capacitor (310) to provide the electrical connection.

**10.** A decoupling capacitor assembly according to claim 9, wherein the carrier (315) comprises a plastics or ceramics material.

**11.** A decoupling capacitor assembly according to claims 10 or 11, wherein the decoupling capacitor (310) comprises a thin film capacitor.

**12.** A decoupling capacitor assembly according to any one of claims 9 to 11, wherein the decoupling capacitor (310) comprises solder pad connectors (350) to connect to the traces.

**13.** A method of fabricating a decoupling capacitor assembly, the method comprising:
providing a carrier (315) for an integrated circuit (312), the carrier (315) comprising a top for receiving an integrated circuit (312) and a base (325) having connectors, the connectors providing an electrical connection to an integrated circuit (312), one of the connectors designated as a power connector and another of the connectors designated as a ground connector; and
electrically connecting a decoupling capacitor (310) to the power and ground connectors, wherein the decoupling capacitor (310) is sized to fit in a space (330) intended to have no connectors on the base (325) of the carrier (315) and between the carrier (315) and a structure (400) to which the carrier (315) is to be connected;
wherein the method further comprises applying preformed traces to the base (325) of the carrier (315) leading from the power and ground connectors to the space (330) and connecting the decoupling capacitor (310) to the traces to form the electrical connection.

**14.** A method according to claim 13, further comprising connecting an integrated circuit (312) to the top of the carrier (315).

**15.** A method according to claim 13 or 14, further comprising applying balls (320) to the connectors on the base (325) of the carrier (315).

**16.** A method according to any one of claims 13 to 15, further comprising assembling the decoupling capacitor assembly into a mobile device (100).

**17.** A mobile device (100) comprising a decoupling capacitor/integrated circuit assembly according to any one of claims 1 to 5.

**18.** A mobile device (100) comprising a decoupling capacitor assembly according to any one of claims 9 to 12.
